# EUROPEAN PATENT APPLICATION

(11) **EP 1 699 056 A1**
(43) Date of publication of application: **06.09.2006**
(21) Application number: 06115412.6
(22) Date of filing: 24.02.2003
(51) Int. Cl.: G11C 29/00, G11C 5/06

(54) **A semiconductor memory module and a multi-layer circuit bord for**

(30) Priority: 26.02.2002 US 360036 P; 20.02.2003 US 371736
(62) Divisional of application: 03713706.4
(71) Applicant: Celetronix International, Ltd, Hamilton HM CX (BM)
(72) Inventor: Peddle, Charles, L., Simi Valley, CA 93065 (US)
(74) Representative: Freeman, Jacqueline Carol

(57) **Abstract**

A method and apparatus for implementing a selectively operable clock booster for DDR memory and other logic modules, which utilize partially-defective memory parts or a combination of partially-defective and flawless memory parts. The method and apparatus include an improved clocking method and system, which enables the use of partially-defective memory parts without distorting the clock signal. In one embodiment, a Phase-Locked Loop circuit and a clock patching network are used to significantly reduce clock distortion on a memory module.

## Description

### RELATED APPLICATIONS

The present invention is related to US Provisional Patent 60/360,036, filed on February 26, 2002, and references co-pending U.S. Patent Application Attorney Docket Nos. 65887-0006, entitled "Improved Patching Methods and Apparatus for Fabricating Memory Modules," filed February 20, 2003, and 65887-0007, entitled "Improved Methods and Apparatus for Fabricating Chip-on-Board Modules," filed February 20, 2003.

### TECHNICAL FIELD

The present invention relates to the field of electronic memory modules. More specifically, embodiments of the present invention relate to the fabrication of DDR memory and other logic modules that selectively use operating segments of a plurality of less-than-perfect chips or packages exclusively, or in combination with perfect ones.

### BACKGROUND

Semiconductor manufacturing processes have become increasingly more complex. From the beginning with the creation of discrete transistors and other semiconductor devices through subsequent medium and large scale integrated devices, the number of transistors or independent elements we can fit on to a semiconductor chip has grown exponentially each year. For example, the first integrated processors comprised on the order of 2300 transistors. A recently announced integrated circuit processor comprises more than 220 million transistors. Other circuits are projected to contain over 1 billion transistors in the foreseeable future.

This continued exponential growth of semiconductor manufacturing processes, while contributing to the greatly decreased costs of individual semiconductor devices and products has also exacerbated many production and testing problems associated with commercial semiconductor manufacturing processes. The substantial increase in the density of electronic circuits in the semiconductor integrated manufacturing processes has resulted in the production of many more less-than-perfect semiconductor die or chips. This increase in the production of less than perfect chips and die has spawned a new market for electronic component sellers who find ways to utilize less-than-perfect chips or die to assemble working components.

The many enhancements and advancements in semiconductor manufacturing and packaging processes have resulted in the creation of a number of price sensitive semiconductor product applications for electronic parts sellers. In particular, these electronic parts sellers develop low cost memory modules or other semiconductor devices through the utilization of cost effective processes and less-than-perfect semiconductor parts.

One particular advancement in memory technology, called DDR (Double Data Rate), has improved (approximately doubled) the read/write access speed of memory by using both the rising edge and falling edge of the driving clock to access memory. Using both the falling edge and rising edge of a clock signal necessitates the use of a clean clock signal.

Often logic modules that use partially-defective memory parts require a greater number of parts in order to provide a desired amount of functional memory. In DDR memory and other logic modules, the driving clock signal will become increasingly distorted as more memory parts are added to a module, i.e., each part adds a resistive load for the clock signal to drive.

A distorted clock signal may often cause errors when accessing memory parts which are sensitive to the rise and fall times of the driving clock. Accordingly, there is a need to provide a clean clock signal capable of driving an indeterminate number of memory parts, some or all of which may be partially defective.

In summary, there is an ongoing need in the art for means and methods of producing low cost semiconductor devices, particularly memory modules. Related to this is an ongoing need to make use of modern, popular devices that are partially-defective so that such devices are not completely wasted.

### SUMMARY OF THE INVENTION

According to one aspect of the present invention there is provided a multi-later circuit board for fabricating a memory module using a selectively operable clock booster and partially-defective memory parts, said circuit board comprising:
means for utilizing an indeterminate number of memory parts; and
means for selectively connecting said clock booster to said memory parts.

According to a second aspect of the present invention there is provided an improved semiconductor memory module having a plurality of primary memory parts and a plurality of secondary backup memory parts arrayed on a printed circuit board to form a predetermined size memory module, said memory module comprising:
a first conductor layout on said printed circuit board to associate individual ones of said primary memory parts with an individual secondary backup memory part to form a primary/secondary memory part paid,
an individual bit patching network associated with each primary/secondary part pair to facilitate replacement of any inoperable I/O output line of a primary part with an operable I/O line of its associated backup memory part to form a fully functional primary/secondary memory part pairs, and
a selectively operable clock booster circuit to correct any degradation of a primary data clock signal as a function of the number of backup memory parts utilized to patch any non-working I/O lines of associated primary memory parts.

### SUMMARY OF SELECTED EMBODIMENTS

In one of many embodiments, the present invention provides a method and apparatus for implementing a selectively operable clock booster for DDR and other memory modules, which utilize partially-defective memory parts or a combination of partially-defective and flawless memory parts. The method and apparatus includes an improved clocking method and system, which enables the use of partially-defective memory parts without distorting the clock signal. In one embodiment, a Phase-Lock Loop circuit is used to significantly reduce clock distortion on a memory module.

In another embodiment, a clock booster circuit may be selectively operated to allow an indeterminate number of memory parts to be used without distorting the clock signal on SDR (Synchronized Data Rate) memory modules.

### BRIEF DESCRIPTION OF THE DRAWINGS

The accompanying drawings illustrate various embodiments of the present invention and are a part of the specification. Together with the following description, the drawings demonstrate and explain the principles of the present invention. The illustrated embodiments are examples of the present invention and do not limit the scope of the invention.

Fig. 1 is a flowchart illustrating a method of fabricating a memory module according to one embodiment of the present invention.

Fig. 2 is a graph illustrating a distortion of a clock signal due to clock skew.

Fig. 3 is a graph illustrating a distortion of a clock signal due to electrical noise.

Fig. 4 illustrates a schematic diagram of a Phase-Lock Loop circuit that may be used as a clock booster for a memory module according to one embodiment of the present invention.

Fig. 5 is a block diagram illustrating a layout of major components of a memory module fabricated according to one embodiment of the present invention.

Fig.6 is a block diagram illustrating a primary and secondary memory part in conjunction with a patching network according to one embodiment of the present invention.

Fig. 7 is a block diagram illustrating a primary and secondary memory part in conjunction with another patching network according to another embodiment of the present invention.

Fig. 8 is a block diagram illustrating a primary and secondary memory part in conjunction with another patching network according to another embodiment of the present invention.

Fig. 9 is a block diagram illustrating a PLL clock driver, which may be selectively connected to a number of primary and secondary memory parts using switches according to one embodiment of the present invention.

Fig. 10 is a block diagram illustrating a PLL clock driver, which may be selectively connected to a number of primary and secondary memory parts using a clock patching network according to another embodiment of the present invention.

Fig. 11 is a block diagram illustrating a PLL clock driver, selectively connected to a number of primary and secondary memory parts according to one embodiment of the present invention.

Throughout the drawings, identical reference numbers designate similar, but not necessarily identical, elements.

### DETAILED DESCRIPTION OF SELECTED EMBODIMENTS

A method and apparatus disclosed herein for manufacturing DDR and other memory modules uses partially-defective memory parts or a combination of partially-defective and flawless memory parts. The method and apparatus include an improved clocking method and system, which enables an indeterminate number of memory parts to be used without distorting the clock signal. In one embodiment, a Phase-Lock Loop circuit is used to significantly reduce clock distortion on DDR and other memory modules.

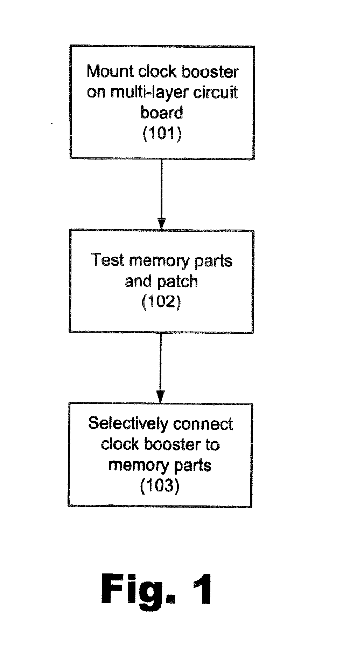

Fig. 1 is a flowchart illustrating a method of fabricating a memory module according to one embodiment. As shown in Fig. 1, a clock booster is mounted on a multi-layer circuit board (101). The clock booster may be any apparatus that receives a clock input, and outputs one or more clock signals capable of driving a multiplicity of logic parts without clock distortion. In a preferred embodiment, a Phase-Locked Loop circuit may be used as a clock booster.

During the fabrication process of a memory module, as described in US Patent No. 6,119,049 or the co-pending patent application referenced above, memory parts are tested and patched (102). The testing and patching (102) allows a fully-functional memory module to be fabricated using partially-defective parts. Due to the load that each memory part adds, it is desirable to only connect the clock signal to those memory parts that are utilized. This may be accomplished using any number of switching mechanisms to connect or disconnect a clock signal to a memory part. In a preferred embodiment, a clock patching network may be used to selectively connect or disconnect outputs of a clock booster to the memory parts (103).

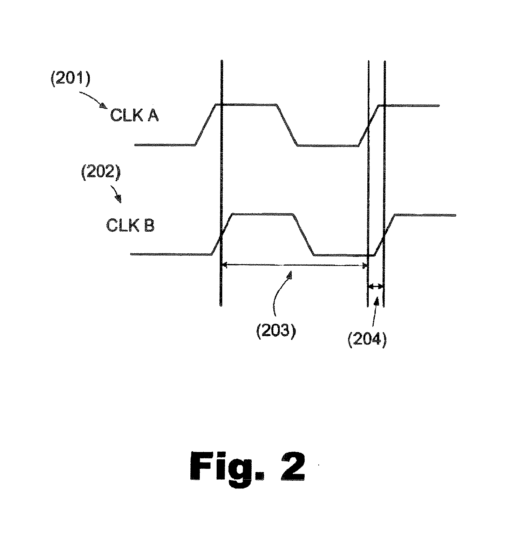

Fig. 2 is a graph illustrating a distortion of a clock signal due to clock skew. In general, clock skew may be described as a decrease of available time in a clock cycle. As shown in Fig. 2, CLK A (201) produces a clock signal with a fixed frequency, and CLK B (202) slightly trails the signal for CLK A (201). Because the two clocks are not synchronized there is a loss (204) in the clock period. For example, if two memory parts were being accessed at the same time, one with CLK A and the other with CLK B, the effective clock period (203) would be reduced because the clock signals are not synchronized. For many memory modules it may be desirable to access up to 16 memory parts at the same time. This makes clock skew an important design issue since clock skew is often caused by variations in the load the clock is driving, etc. In particular, applications such as DDR that use both the rising and falling edge of a clock are sensitive to reductions in clock period caused by clock skew.

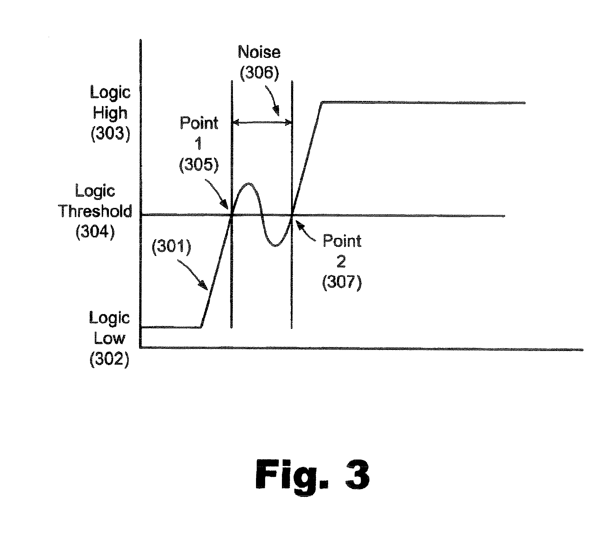

Fig. 3 is a graph illustrating a distortion of a clock signal due to electrical noise. Electrical noise is common in high frequency electrical applications, and is detrimental in memory units. As shown in Fig. 3, a clock signal (301) is rising from a logic low level (302) to a logic high level (303). Most devices, such as a memory part, use a logic threshold level (304) to distinguish when a clock signal (301) is "high" or "low." For example, when the clock signal (301) reaches point 1 (305), a device using the clock signal will recognize a logic high (303), but a period of electrical noise (306) on the clock signal may cause the clock (301) signal to dip below the logic threshold value (304), resulting in extraneous clocking when the clock signal (301) again crosses the logic threshold value (304) at point 2 (307). A period of electrical noise (306) on a clock signal (301) may consequently cause double clocking, false clocking, and waveform distortion, etc.

In order to improve clock performance, devices such as phase-locked loops, amplifiers, filters, etc., may be used. In one embodiment that uses a variable number of memory parts, a device that strengthens a clock signal to allow a high number of memory parts to be driven by that clock signal is desirable.

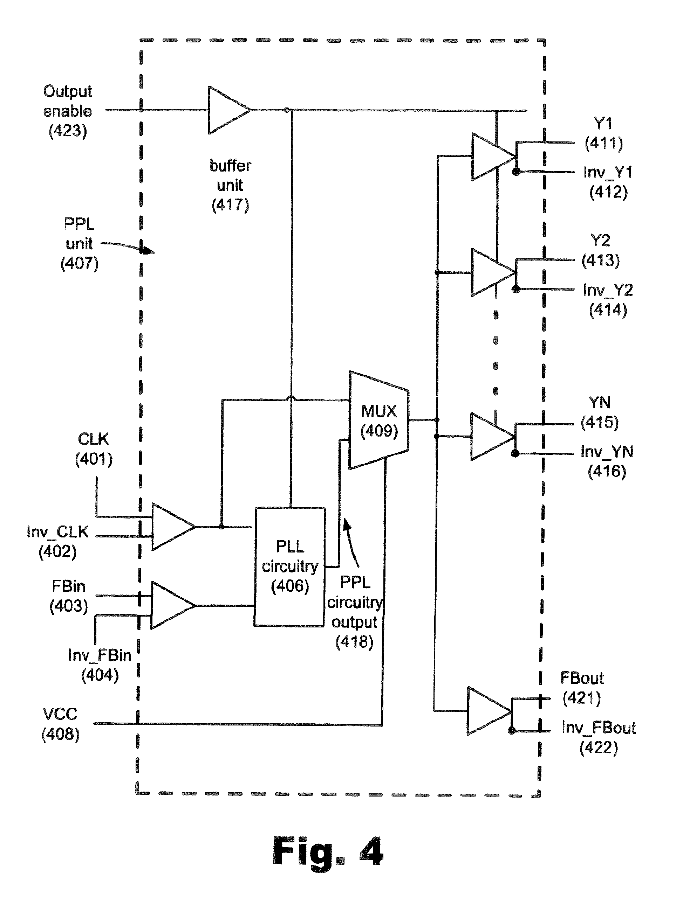

Fig. 4 illustrates a schematic diagram of a Phase-Locked Loop circuit that may be used as a clock booster for a memory module according to one embodiment of the present invention. As shown in Fig. 4, a PPL unit (407) may comprise a number of buffer units (417), PPL circuitry (406), and a mux (409). Several signals, including a clock signal, CLK (401), Inv_CLK (402), FBin (403), Inv_FBin (404), VCC (408), and Output Enable (423) are supplied as input signals to the PPL unit (407).

In this embodiment, CLK (401) may be a clock signal input designed to drive DDR or other memory parts at a designed frequency. Inv_CLK (402) is the same as CLK (401), but shifted 180 degrees. FBin (403) is a copy of the output clock signal, FBout (421), of the PPL unit (407), which is used to ensure the outputs (411-416) are synchronized with the incoming CLK (401) signal. Inv_FBin (404) is a copy of the output clock signal, Inv_FBout (422), of the PPL unit (407) shifted by 180 degrees. VCC (408) is an input voltage to the mux (409) that may be used to determine if GLK (401) will be the output from the PPL unit (407) or if the output (418) from the PPL circuitry (406) will be the output from the PPL unit (407). Output Enable (423) allows a host device to control when the PPL unit (407) outputs a signal. Y1-YN (411-416) comprise a number of outputs from the PPL unit (407). More specifically, Y1-YN (411-416) are synchronized copies or phase shifted copies of CLK (401) and Inv_CLK (402).

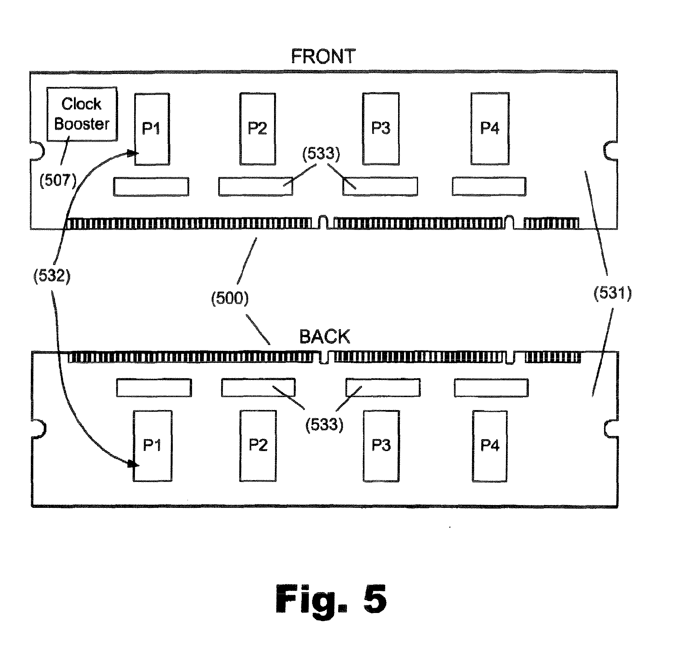

Fig. 5 is a block diagram illustrating a layout of major components of a memory module fabricated according to one selected embodiment. In particular, a 64M(megabytes), 128M, or 256M DDR or SDR memory module fabricated using 8Mx8, 16Mx8, or 32Mx8 memory parts may be illustrated by the memory module of Fig. 5. As shown in Fig. 5, the memory module (500) may comprise a multi-layer circuit board (531), paired memory parts (532), patching networks (533), and a selectively operable clock booster (507), such as the PPL unit (407, Fig. 4) shown in Fig. 4. The paired memory parts (532) are designated by P1, P2, P3, and P4, with each pair preferably comprising one primary and one secondary memory part.

During the fabrication process, the patching networks (533) are utilized as described below. Once a determination of possible patching solutions is realized, the selectively operable clock booster (507) may be used to effectively drive the primary and secondary memory parts (532) whose I/O bits are accessed.

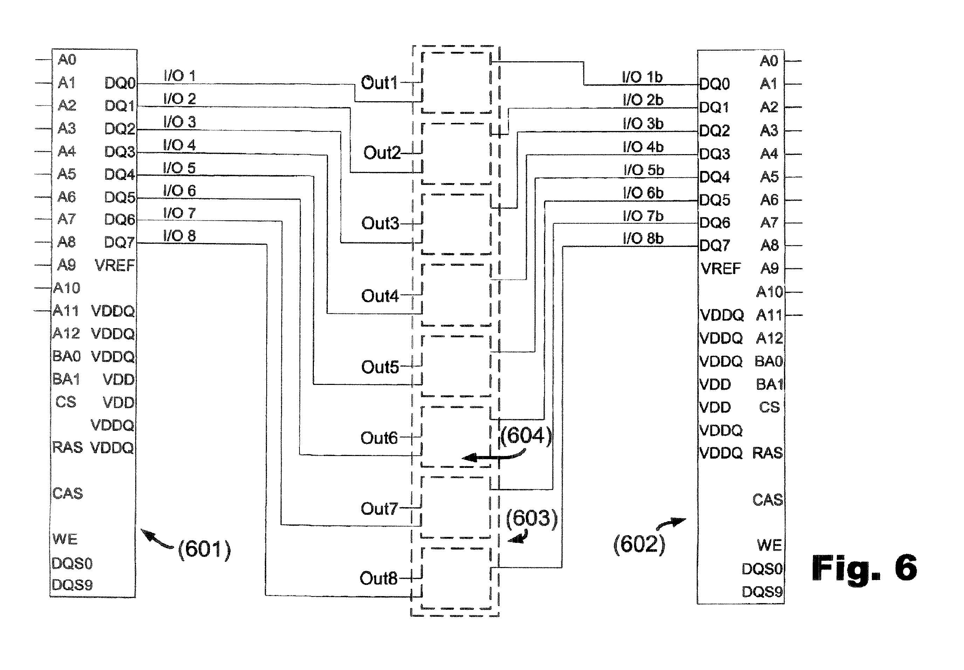

Fig. 6 is a block diagram illustrating a primary and secondary memory part in conjunction with a patching network. As shown in Fig. 6, the I/O lines (I/O 1-I/O 8) of a primary memory part (601) may be connected to pads (604) of a patching network (603). In this embodiment, each pad (604) to which a separate primary I/O line is connected is preferably close to a separate output line (Out1-Out8). Additionally, the backup I/O lines (I/O 1b-I/O 8b) from a secondary memory part (602) are also connected to pads (604) of the patching network (603). As described for the primary I/O lines, each pad (604) to which a separate backup I/O line (I/O 1b-I/O 8b) is connected is preferably close to a separate output line. As shown in Fig. 6, the pads (604) connected to I/O lines, I/O 1 and I/O 1b, are close to the pad (604) connected to output line, Out1. This configuration of pads (604) used as a patching network (603) preferably allows one primary I/O line to be replaced by one backup I/O line. For example, I/O 1 may be replaced by I/O 1b, I/O 2 may be replaced by I/O 2b, etc.

During the fabrication process of a memory module, the patching network (603) is used to connect a primary or secondary I/O line to an output line (Out1-Out8). This may be accomplished by connecting a single pad (604) corresponding to a primary I/O line or backup I/O line to a single pad (604) corresponding to an output line. Electrically conductive materials, e.g., solder, jumper wires, etc., may be used to connect pads (604) of the patching network (603) to allow a host device to access the I/O bits of a primary memory part (601) or secondary memory part (602).

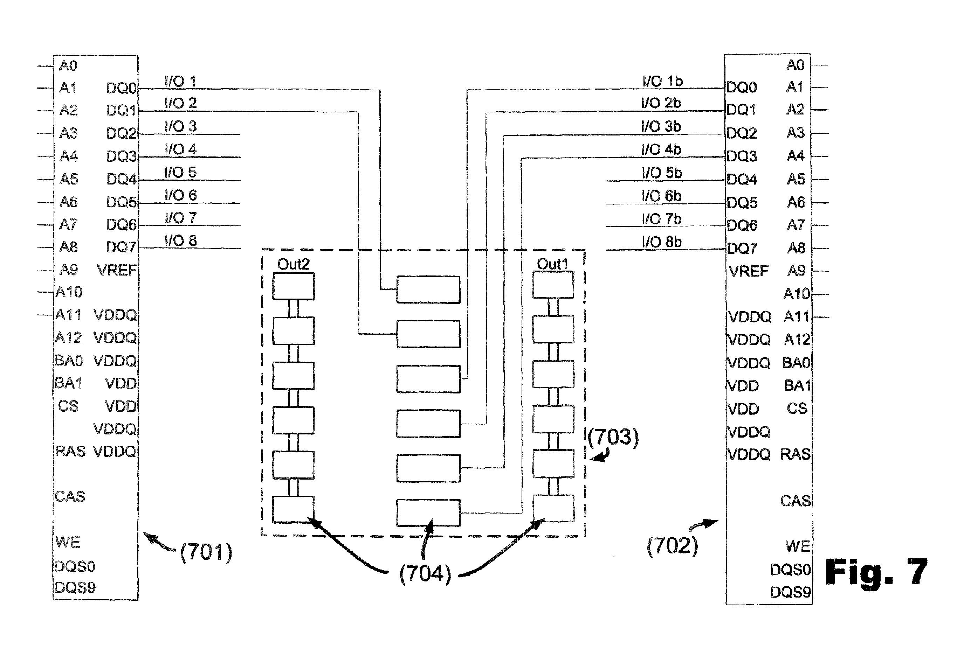

Fig. 7 is a block diagram illustrating a primary and secondary memory part in conjunction with another patching network. As shown in Fig. 7, two I/O lines (I/O 1-I/O 2) of a primary memory part (701) may be connected to two separate pads (704) of a patching network (703). Additionally, four backup I/O lines (I/O 1b-I/O 4b) are connected to four other pads (704) of the patching network (703).

In this embodiment, each output line (Out1-Out2) is connected to a series of pads (704), thus providing a separate connective pad (704) adjacent to each pad (704) corresponding to an I/O line. For example, Fig. 7 illustrates two primary I/O lines and four backup I/O lines connected to six separate pads (704) of the patching network (703). Therefore, each output line is connected to six pads (704) adjacent to the pads (704) corresponding to the primary and secondary I/O lines.

The illustration of Fig. 7 is incomplete in that only one patching network (703) is shown. In order to use the other primary I/O lines (I/O 3-I/O 8), additional patching networks (703) are preferred, wherein two primary I/O lines and four backup I/O lines are connected to each patching network (703). Therefore, a memory module using the patching configuration shown in Fig. 7, would preferably use four patching networks (703) for each primary memory part (701) and secondary memory part (702) pair. Additionally, the spacing between the pads (704) shown in Fig. 7 is for illustrative purposes only. In a real implementation, pads (704) are preferably close together, thus allowing electrical connections between pads (704) corresponding to I/O lines and pads (704) corresponding to output lines to be easily made.

During the fabrication process of a memory module, the patching network (703) is used to connect a primary or secondary I/O line to an output line (Outl-Out2). This may be accomplished by connecting a single pad (704) corresponding to a primary I/O line or backup I/O line to one of six pads (704) corresponding to each output line. Electrically conductive materials, e.g., solder, jumper wires, etc., may be used to connect pads (704) of the patching network (703) to allow a host device to access the I/O bits of a primary memory part (701) or secondary memory part (702).

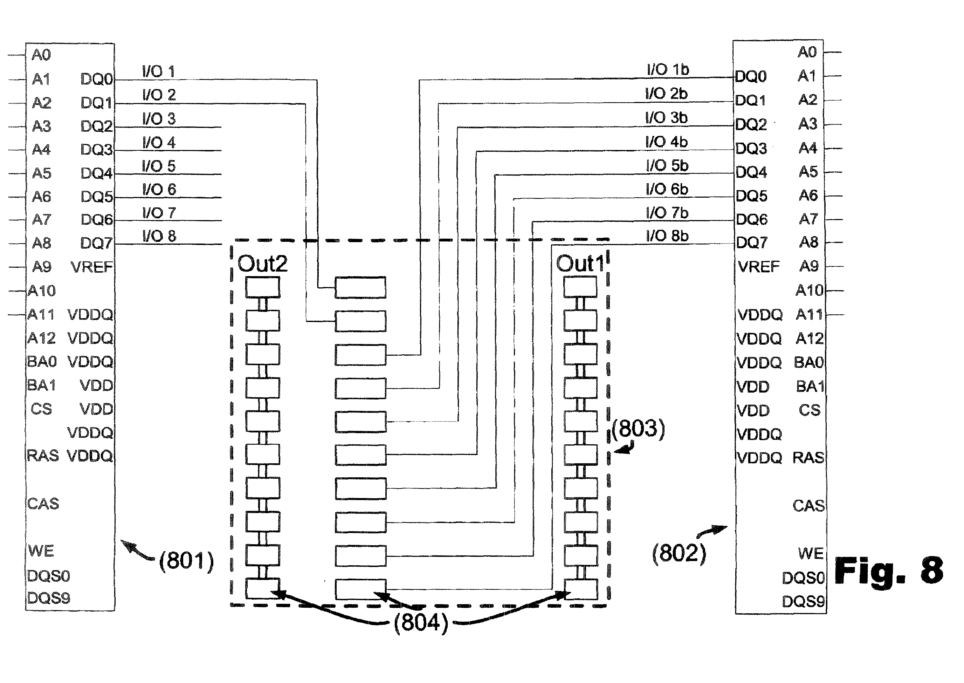

Fig. 8 is a block diagram illustrating a primary and secondary memory part in conjunction with another patching network. As shown in Fig. 8, two I/O lines (I/O 1-I/O 2) of a primary memory part (801) may be connected to two separate pads (804) of a patching network (803). Additionally, eight backup I/O lines (I/O 1b-I/O 8b) are connected to eight other pads (804) of the patching network (803).

In this embodiment, each output line (Out1-Qut2) is connected to a series of pads (804), thus providing a separate connective pad (804) adjacent to each pad (804) corresponding to an I/O line. For example, Fig. 7 illustrates two primary I/O lines and eight backup I/O lines connected to ten separate pads (804) of the patching network (803). Therefore, each output line is connected to ten pads (804) adjacent to the pads (804) corresponding to the primary and secondary I/O lines.

The illustration of Fig. 8 is incomplete in that only one patching network (803) is shown. In order to use the other primary I/O lines (I/O 3-I/O 8), additional patching networks (803) are preferred, wherein two primary I/O lines and all eight backup I/O lines are connected to each patching network (803). Therefore, a memory module using the patching configuration shown in Fig. 8, would preferably use four patching networks (803) for each primary memory part (801) and secondary memory part (802) pair. Additionally, the spacing between the pads (804) shown in Fig. 8 is for illustrative purposes only. In a real implementation, pads (804) are preferably close together, thus allowing electrical connections between pads (804) corresponding to I/O lines and pads (804) corresponding to output lines to be easily made.

During the fabrication process of a memory module, the patching network (803) is used to connect a primary or secondary I/O line to an output line (Out1-Out2). This may be accomplished by connecting a single pad (804) corresponding to a primary I/O line or backup I/O line to one of ten pads (804) corresponding to each output line. Electrically conductive materials, e.g., solder, jumper wires, etc., may be used to connect pads (704) of the patching network (703) to allow a host device to access the I/O bits of a primary memory part (701) or secondary memory part (702).

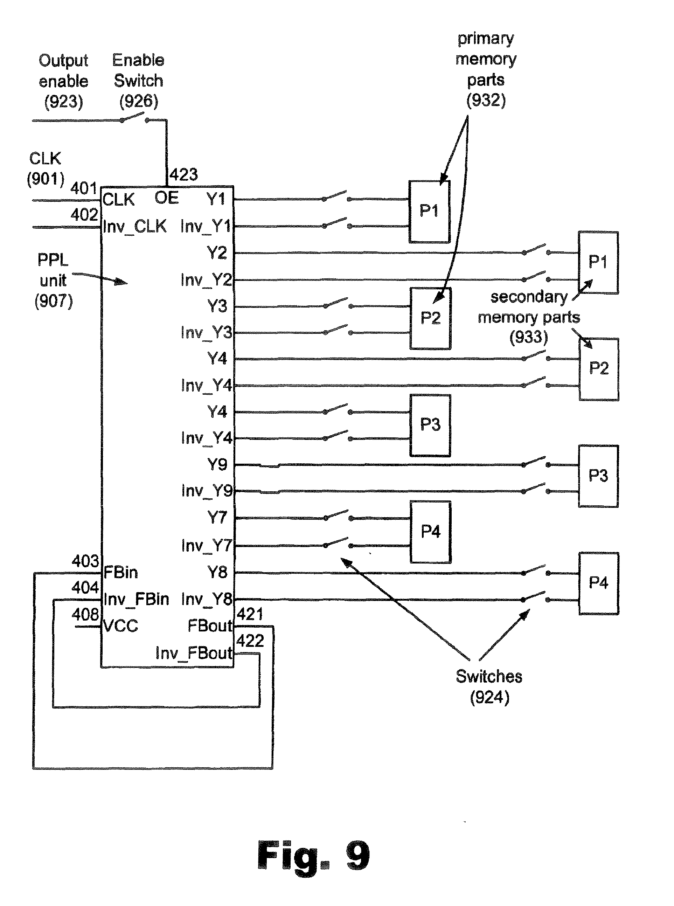

Fig. 9 is a block diagram illustrating a PLL clock driver, which may be selectively connected to a number of memory parts in one selected embodiment. As shown in Fig. 9, a PPL unit (907), e.g., the PPL unit (407, Fig. 4) described in Fig. 4, receives a clock signal, CLK (901), from which a number of outputs (synthesized copies of the incoming clock signal) are created. These outputs are connected to primary memory parts (932) and secondary memory parts (933) through switches (924). The switches (924) may selectively be opened or closed, thereby allowing a clock signal to be used preferably only with memory parts (932, 933) whose I/O lines are accessed. Additionally, the PPL unit (907) may be enabled or disabled using an enable switch (926).

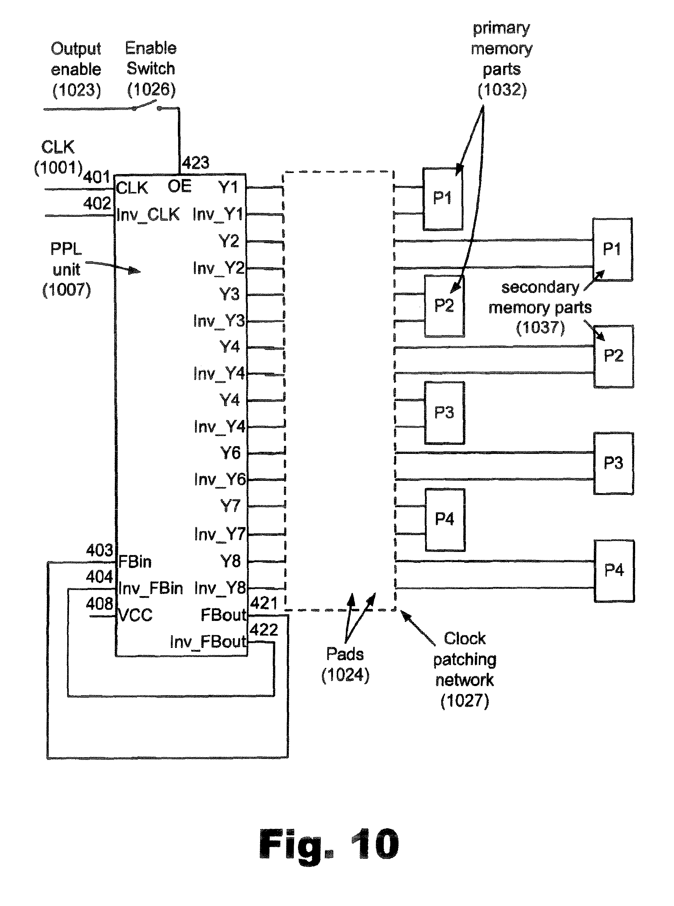

Fig. 10 is similar to Fig. 9 in that Fig. 10 is a block diagram illustrating a PLL clock driver, which may be selectively connected to a number of memory parts. As shown in Fig. 10, a PPL unit (1007), e.g., the PPL unit (407, Fig. 4) described in Fig. 4, receives a clock signal, CLK (1001), from which a number of outputs (synthesized copies of the incoming clock signal) are created. These outputs may preferably be connected to primary memory parts (1032) and secondary memory parts (1033) through a clock patching network (1025), which uses pads (1024) to selectively complete a connection, thereby allowing a clock signal to be used preferably only with memory parts (1032, 1033) whose I/O lines are accessed. Additionally, the PPL unit (1007) may be enabled or disabled using an enable switch (1026).

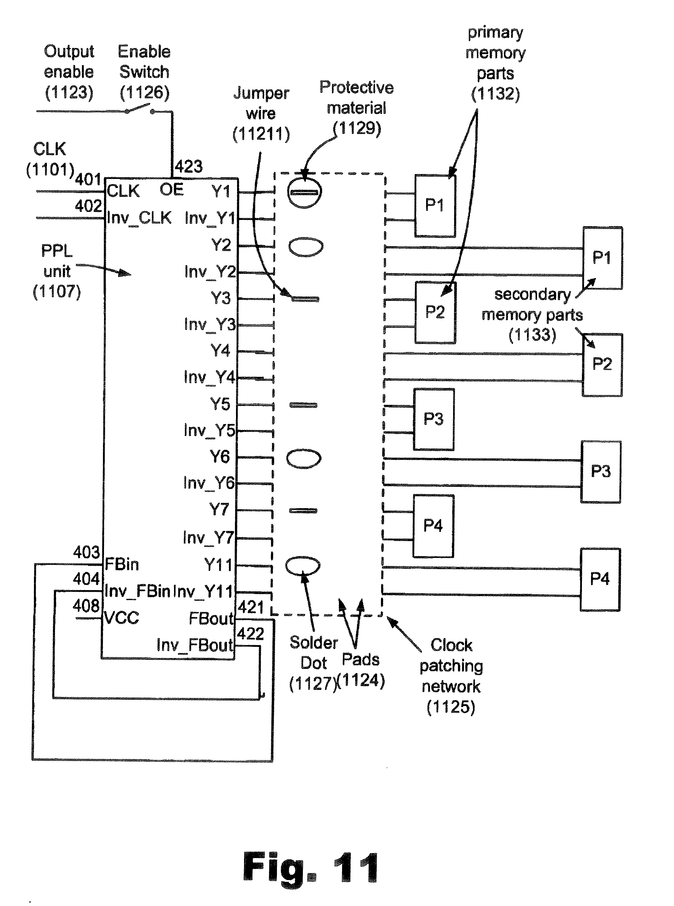

Fig. 11 is a block diagram illustrating a PLL clock driver, selectively connected to a number of memory parts. As shown in Fig. 11, a PPL unit (1107), e.g., the PPL unit (407, Fig. 4) described in Fig. 4, receives a clock signal, CLK (1101), from which a number of outputs (synthesized copies of the incoming clock signal) are created. These outputs may preferably be connected to primary memory parts (1132) and secondary memory parts (1133) through a clock patching network (1125), which uses pads (1124) to selectively complete a connection, thereby allowing a clock signal to be used preferably only with memory parts (832, 833) whose I/O lines are accessed. Additionally, the PPL unit (1107) may be enabled or disabled using an enable switch (1126).

With connecting pads (1124), one of several methods may be used. As illustrated in Fig. 11, solder dots (1127) or jumper wires (1128) may be used. Additionally, a protective material (1129), e.g., a thermally curable material, may be used to physically protect jumper wires (1128), solder dots (1127), etc.

As also shown in Fig. 8, all of the memory parts (1132, 1133) are connected to a clock output from the PPL (1107) with exception of the secondary memory part (1133) associated with the memory part pair, P2. As described above, this illustration is preferable if I/O lines of all memory parts are utilized to create a fully-functional memory module except the secondary memory part of P2.

The preceding description has been presented only to illustrate and describe embodiments of invention. It is not intended to be exhaustive or to limit the invention to any precise form disclosed. Many modifications and variations are possible in light of the above teaching. It is intended that the scope of the invention be defined by the following claims.

## Claims

1. A multi-later circuit board for fabricating a memory module using a selectively operable clock booster and partially-defective memory parts, said circuit board comprising:
means for utilizing an indeterminate number of memory parts; and
means for selectively connecting said clock booster to said memory parts.

2. The multi-layer circuit board of claim 1, wherein said means for utilizing an indeterminate number of memory parts comprises patching networks.

3. The multi-layer circuit board of claim 1 or 2, wherein said means for selectively connecting said clock booster to said memory parts comprises a clock patching network.

4. An improved semiconductor memory module having a plurality of primary memory parts and a plurality of secondary backup memory parts arrayed on a printed circuit board to form a predetermined size memory module, said memory module comprising:
a first conductor layout on said printed circuit board to associate individual ones of said primary memory parts with an individual secondary backup memory part to form a primary/secondary memory part paid,
an individual bit patching network associated with each primary/secondary part pair to facilitate replacement of any inoperable I/O output line of a primary part with an operable I/O line of its associated backup memory part to form a fully functional primary/secondary memory part pairs, and
a selectively operable clock booster circuit to correct any degradation of a primary data clock signal as a function of the number of backup memory parts utilized to patch any non-working I/O lines of associated primary memory parts.

5. The improved memory module of claim 4 wherein said memory module comprises a DDR memory module.

6. The improved memory module of claim 4, wherein said memory module comprises a SDR memory module.

7. The improved memory module of claim 4, 5 or 6, wherein said clock booster circuit comprises a phase lock loop amplifier for generating a revitalized and resynchronized clock circuit for driving predetermined ones of said primary/secondary memory part pairs.

8. The improved memory module of claim 4, 5, 6 or 7 further comprising:
a stack array of a plurality of parallel arranged printed circuit board members;
a plurality of said primary memory parts and of said secondary backup memory parts arranged on each PC board to form a predetermined total memory capacity;
a memory module data clock booster circuit located on at least one of said plurality of stacked PC board members; and
a switch for selectively actuating said clock booster circuit as a function of a number of primary and secondary memory parts utilized to provide operable I/O lines to form a fully operable memory module.
